(19) Europäisches Patentamt
European Patent Office
Office européen des brevets

(11) **EP 1 630 149 B1**

(12) **EUROPEAN PATENT SPECIFICATION**

(45) Date of publication and mention
of the grant of the patent:
**09.10.2013 Bulletin 2013/41**

(51) Int Cl.:
***C04B 35/495*** (2006.01)     ***C04B 35/499*** (2006.01)
***H01L 41/187*** (2006.01)

(21) Application number: **04745428.5**

(22) Date of filing: **28.05.2004**

(86) International application number:
**PCT/JP2004/007392**

(87) International publication number:
**WO 2004/106264 (09.12.2004 Gazette 2004/50)**

(54) **PIEZOELECTRIC CERAMIC COMPOSITION AND PIEZOELECTRIC ELEMENT INCLUDING THE SAME**

PIEZOELEKTRISCHE KERAMIKZUSAMMENSETZUNG UND DIESE ENTHALTENDES PIEZOELEKTRISCHES ELEMENT

COMPOSITION CERAMIQUE PIEZO-ELECTRIQUE ET ELEMENT PIEZO-ELECTRIQUE COMPRENANT CETTE COMPOSITION

(84) Designated Contracting States:
**DE FR GB IT**

(30) Priority: **29.05.2003 JP 2003153426**

(43) Date of publication of application:
**01.03.2006 Bulletin 2006/09**

(73) Proprietor: **NGK Spark Plug Co., Ltd.**
**Nagoya-shi,**
**Aichi 467-0872 (JP)**

(72) Inventors:
• **YAMAZAKI, Masato,**
**NGK SPARK PLUG CO., LTD.**
**Nagoya-shi,**
**Aichi 4670872 (JP)**
• **ITO, Kohei,**
**NGK SPARK PLUG CO., LTD.**
**Nagoya-shi,**
**Aichi 4670872 (JP)**
• **YAMAGIWA, Katsuya,**
**NGK SPARK PLUG CO., LTD.**
**Nagoya-shi,**
**Aichi 4670872 (JP)**
• **OKIMURA, Yasuyuki,**
**NGK SPARK PLUG CO., LTD.**
**Nagoya-shi,**
**Aichi 4670872 (JP)**
• **MITSUOKA, Takeshi,**
**NGK SPARK PLUG CO., LTD.**
**Nagoya-shi,**
**Aichi 4670872 (JP)**

• **OBAYASHI, Kazushige,**
**NGK SPARK PLUG CO., LTD.**
**Nagoya-shi,**
**Aichi 4670872 (JP)**

(74) Representative: **Tyson, Robin Edward**
**J A Kemp**
**14 South Square**
**Gray's Inn**
**London WC1R 5JJ (GB)**

(56) References cited:
JP-A- 11 228 225     JP-A- 11 228 227
JP-A- 11 240 759     JP-A- 2001 240 471
JP-A- 2001 342 065   JP-A- 2002 068 835
JP-A- 2002 255 641   JP-A- 2003 206 179
US-A1- 2002 060 306  US-A1- 2002 098 968

• DATABASE WPI Week 199944 Thomson Scientific, London, GB; AN 1999-519756 XP002507248 -& JP 11 228226 A (MURATA MFG CO LTD) 24 August 1999 (1999-08-24)
• DATABASE WPI Week 200232 Thomson Scientific, London, GB; AN 2002-273775 XP002507249 -& JP 2001 316182 A (KYOCERA CORP) 13 November 2001 (2001-11-13)
• DATABASE WPI Week 200211 Thomson Scientific, London, GB; AN 2002-077807 XP002507250 -& JP 2001 240471 A (KYOCERA CORP) 4 September 2001 (2001-09-04)

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- **DATABASE WPI Week 200136 Thomson Scientific, London, GB; AN 2001-191749 XP002507251 -& JP 2001 143907 A (null) 25 May 2001 (2001-05-25)**

**Description**

Technical Field

The present invention relates to a piezoelectric ceramic composition and to a piezoelectric element. More particularly, the present invention relates to a piezoelectric ceramic composition which contains substantially no lead, which exhibits excellent piezoelectric characteristics, and which has excellent heat durability; and to a piezoelectric element comprising the composition.
The piezoelectric ceramic composition and piezoelectric element of the present invention are widely employed in, for example, vibration sensors, pressure sensors, oscillators, and piezoelectric devices. For example, the piezoelectric ceramic composition and the piezoelectric element can be employed in a variety of piezoelectric devices such as vibration sensors (e.g., a knock sensor or a combustion pressure sensor), vibrators, actuators, and filters; high-voltage-generating devices; micro power supplies; a variety of driving devices; position control devices; vibration control devices; and fluid discharge devices (e.g., a paint discharge device or a fuel discharge device). Particularly, the piezoelectric ceramic composition and the piezoelectric element are suitable for use in devices requiring excellent heat durability (e.g., a knock sensor or a combustion pressure sensor).

Background Art

Existing mass-produced piezoelectric ceramic materials generally contain lead. Such a lead-containing piezoelectric ceramic material requires a high processing cost, in view that detrimental effects of lead on the environment must be avoided, and therefore, demand has arisen for development of a lead-free piezoelectric ceramic material. Currently known lead-free piezoelectric ceramic materials include $(Bi_{0.5}Na_{0.5})TiO_3$ compounds and bismuth layered compounds. However, such a lead-free piezoelectric ceramic material has a piezoelectric strain constant lower than that of a lead-containing piezoelectric ceramic material, and thus raises a problem in that the amount of strain is small with respect to an applied voltage, or the amount of generated voltage is small with respect to an applied stress. Therefore, such a lead-free piezoelectric ceramic material is difficult to employ particularly in an active element such as a vibrator. Meanwhile, each of the below-described Patent Documents 1 and 2 discloses a piezoelectric ceramic material predominantly containing an alkali metal niobate based compound.

Patent Document 1: Japanese Patent Publication (*kokoku*) No. 56-12031
Patent Document 2: Japanese Patent Application Laid-Open (***kokai***) No. 11-228227

Disclosure of the Invention

Problems to be Solved by the Invention

Patent Document 1 discloses a piezoelectric ceramic material containing $(K_xNa_{1-x})NbO_3$ with iron oxide and/or cobalt oxide. The material raises a problem in that a sufficient relative dielectric constant is difficult to attain. Meanwhile, Patent Document 2 discloses a piezoelectric ceramic composition predominantly containing $(K_{1-x-y}Na_xLi_y)(Nb_{1-z}Ta_z)$ $O_3$- m1m2O$_3$ (wherein m1 represents a divalent metallic element and m2 represents a tetravalent metallic element), which composition exhibits a relative dielectric constant higher than that of the material disclosed in Patent Document 1. However, these alkali metal niobate based compounds are considerably difficult to sinter, and therefore, demand has arisen for a piezoelectric ceramic material which can be reliably sintered. In addition, demand has arisen for a piezoelectric ceramic material exhibiting further improved piezoelectric characteristics (e.g., piezoelectric strain constant and electromechanical coupling coefficient).
Furthermore, demand has arisen for a piezoelectric ceramic material exhibiting such a high heat durability that it can be employed in a device which is exposed to a high-temperature atmosphere (e.g., a knock sensor or a combustion pressure sensor).
The present invention has been made to solve the aforementioned problems, and objects of the present invention are to provide a piezoelectric ceramic composition which contains substantially no lead, which exhibits excellent sinterability, which exhibits excellent piezoelectric characteristics (electromechanical coupling coefficient, piezoelectric strain constant, and relative dielectric constant), and which has excellent heat durability; and to provide a piezoelectric element comprising the composition.

Means for Solving the Problems

The present invention provides the following.

(1) A piezoelectric ceramic composition characterized by containing metallic element K; metallic element Na; metallic element Nb; M1, which represents a divalent metallic element, or a combination of metallic elements (hereinafter may be referred to as a "metallic element combination") formally equivalent to a divalent metallic element; M2, which represents a tetravalent metallic element, or a metallic element combination formally equivalent to a tetravalent metallic element; M3, which represents a metallic element of a sintering aid component; and non-metallic element O, wherein, when K, Na, Nb, M1, and M2 constitute the formula (1/2) $aK_2O$- (1/2) $bNa_2O$- $cM1O$- (1/2) $dNb_2O_5$- $eM2O_2$], a, b, c, d, and e in the formula satisfy the following relations: $0 < a < 0.5$, $0 < b < 0.5$, $0 < c < 0.11$, $0.4 < d < 0.56$, $0 < e < 0.12$, $0.4 < a + b + c \leq 0.5$, and $a + b + c + d + e = 1$; and when the total amount of K, Na, Nb, M1, and M2 as reduced to corresponding oxides is 100 parts by mass, the amount of M3 as reduced to M3 oxide is 5 parts by mass or less.

(2) A piezoelectric ceramic composition as described in (1) above, wherein, when the total amount of K, Na, Nb, M1, and M2 as reduced to corresponding oxides is 100 parts by mass, the amount of M3 as reduced to M3 oxide is 0.1 parts by mass or more.

(3) A piezoelectric ceramic composition as described in (1) or (2) above, wherein M1 is at least one of Ca, Sr, Ba, $(Bi_{0.5}Na_{0.5})$, and $(Bi_{0.5}K_{0.5})$ .

(4) A piezoelectric ceramic composition as described in any of (1) through (3) above, wherein M2 is at least one of Ti, Zr, and Sn.

(5) A piezoelectric ceramic composition as described in any of (1) through (4) above, wherein M3 is at least one of Fe, Co, Ni, Mg, Zn, and Cu.

(6) A piezoelectric ceramic composition as described in any of (1) through (5) above, wherein M3 is a combination of Cu and at least one of Fe, Co, Ni, Mg, and Zn.

(7) A piezoelectric ceramic composition as described in any of (1) through (6) above, wherein a, b, and d in the formula satisfy the following relation: $(a + b)/d$ s 1.00.

(8) A piezoelectric ceramic composition as described in any of (1) through (7) above, wherein a, b, and c in the formula satisfy the following relation: $0 < c/(a + b + c)$ s 0.20.

(9) A piezoelectric ceramic composition as described in any of (1) through (8) above, which contains, in addition to K, Na, Nb, M1, M2, and M3, metallic element Li, wherein at least one of K and Na in the formula is partially substituted by Li.

(10) A piezoelectric ceramic composition as described in any of (1) through (9) above, which contains, in addition to K, Na, Nb, M1, M2, and M3, metallic element Ta, wherein Nb in the formula is partially substituted by Ta.

(11) A piezoelectric ceramic composition as described in any of (1) through (9) above, which contains, in addition to K, Na, Nb, M1, M2, and M3, metallic element Sb, wherein Nb in the formula is partially substituted by Sb.

(12) A piezoelectric ceramic composition as described in any of (1) through (11) above, which has a perovskite crystal structure.

(13) A piezoelectric ceramic composition as described in (12) above, wherein perovskite crystals belong to an orthorhombic system.

(14) A piezoelectric element characterized by comprising a piezoelectric member formed of a piezoelectric ceramic composition as recited in any of (1) through (13) above; and at least a pair of electrodes which are in contact with the piezoelectric member.

Effects of the Invention

The piezoelectric ceramic composition of the present invention exhibits excellent heat durability. Since the piezoelectric ceramic composition contains M3, which represents a metallic element of a sintering aid, the composition exhibits excellent sinterability. In the piezoelectric ceramic composition, when the total amount of K, Na, Nb, M1, and M2 as reduced to corresponding oxides is 100 parts by mass, the amount of M3 as reduced to M3 oxide is 5 parts by mass or less. Therefore, the piezoelectric ceramic composition exhibits excellent performance in a well-balanced manner without impairing piezoelectric characteristics (including electromechanical coupling coefficient, piezoelectric strain constant, and relative dielectric constant). The piezoelectric ceramic composition of the present invention, which contains substantially no lead (Pb), is advantageous from the viewpoint of environmental protection. As used herein, the expression "a piezoelectric ceramic composition which contains substantially no lead (Pb)" refers to the case where the composition does not contain intentionally added Pb (metallic element). Thus, a piezoelectric ceramic composition containing, as an unavoidable impurity, lead in a very small amount (generally less than 1,000 ppm) is acceptable in the present invention. However, from the viewpoint of reliable environmental protection, a piezoelectric ceramic composition containing no lead is preferred.

When the total amount of K, Na, Nb, M1, and M2 as reduced to corresponding oxides is 100 parts by mass, preferably, the amount of M3 as reduced to M3 oxide is 0.1 parts by mass or more. This is because, when the amount of M3 falls within the above range, sintering of the piezoelectric ceramic composition can be well promoted.

When M1 is a predetermined metallic element or a predetermined metallic element combination, the piezoelectric ceramic composition exhibits further excellent piezoelectric characteristics.

When M2 is a predetermined metallic element or a predetermined metallic element combination, the piezoelectric ceramic composition exhibits further excellent piezoelectric characteristics.

When M3 is at least one of Fe, Co, Ni, Mg, Zn, and Cu, or M3 is a combination of Cu and at least one of Fe, Co, Ni, Mg, and Zn, the piezoelectric ceramic composition exhibits particularly excellent sinterability.

When a, b, and c of the aforementioned formula satisfy the following relation: $0 < c/(a + b + c) \leq 0.20$, the piezoelectric ceramic composition exhibits further excellent piezoelectric characteristics.

When a, b, and d of the aforementioned formula satisfy the following relation: $(a + b)/d \leq 1.00$, the piezoelectric ceramic composition exhibits further excellent sinterability.

When at least one of K and Na in the aforementioned formula is partially substituted by Li, the piezoelectric ceramic composition maintains excellent heat durability and sinterability as in the case where neither K nor Na is subjected to substitution, and the composition exhibits excellent piezoelectric characteristics (including electromechanical coupling coefficient, piezoelectric strain constant, and relative dielectric constant) in a well-balanced manner.

When Nb in the aforementioned formula is partially substituted by Ta, the piezoelectric ceramic composition maintains excellent heat durability and sinterability as in the case where Nb is not subjected to substitution, and the composition exhibits excellent piezoelectric characteristics (including electromechanical coupling coefficient, piezoelectric strain constant, and relative dielectric constant) in a well-balanced manner.

When Nb in the aforementioned formula is partially substituted by Sb, the piezoelectric ceramic composition maintains excellent heat durability and sinterability as in the case where Nb is not subjected to substitution, and the composition exhibits excellent piezoelectric characteristics (including electromechanical coupling coefficient, piezoelectric strain constant, and relative dielectric constant) in a well-balanced manner. In addition, generation of leakage current can be considerably suppressed during the course of polarization treatment.

When the piezoelectric ceramic composition has a perovskite crystal structure, the composition exhibits further excellent piezoelectric characteristics. Particularly preferably, $c/(a + b + c)$ is regulated so as to become greater than zero and 0.20 or less. As used herein, "$c/(a + b + c)$" represents the ratio by mole of M1 to the metallic elements constituting the A sites of the perovskite crystal structure. When the ratio of M1 (metallic element) is regulated so as to fall within a predetermined range, the piezoelectric ceramic composition can be provided with improved piezoelectric characteristics, as well as heat durability sufficient for use at high temperature.

When the perovskite crystals belong to the orthorhombic system, the piezoelectric ceramic composition exhibits particularly excellent piezoelectric characteristics.

The piezoelectric element of the present invention exhibits excellent heat durability. The piezoelectric element exhibits excellent piezoelectric characteristics (including electromechanical coupling coefficient, piezoelectric strain constant, and relative dielectric constant) in a well-balanced manner.

Brief Description of the Drawing

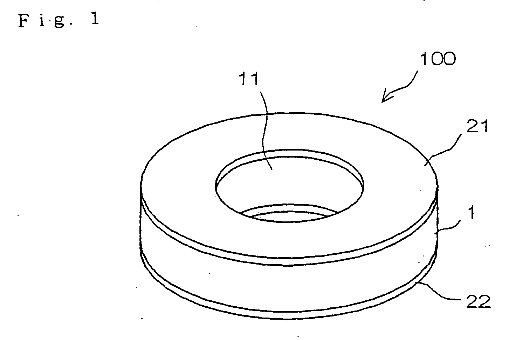

[Fig. 1] Perspective view showing an example of the piezoelectric element of the present invention.

Description of Reference Numerals

  100: Piezoelectric element
  1: Piezoelectric member
  11: Through hole
  21, 22: Electrically conductive layer

Best Mode for Carrying Out the Invention

The present invention will next be described in detail.

Piezoelectric ceramic composition

[1] The piezoelectric ceramic composition of the present invention contains metallic element K, metallic element Na, metallic element Nb, M1 (a divalent metallic element, or a metallic element combination formally equivalent to a divalent metallic element), M2 (a tetravalent metallic element, or a metallic element combination formally equivalent to a tetravalent metallic element), M3 (a metallic element of a sintering aid component), and non- metallic element O.

As described above, "M1" represents a divalent metallic element, or a metallic element combination formally equivalent to a divalent metallic element.

As used herein, the expression "metallic element combination formally equivalent to a divalent metallic element" (hereinafter may be referred to simply as "divalent combination") refers to the following combinations (1) to (4) :

(1) a combination of non- divalent metallic elements (hereinafter may be referred to as a "non- divalent metallic element combination"), such as $(Bi_{0.5}Na_{0.5})$, $(Bi_{0.5}K_{0.5})$, or $(Bi_{0.5}Li_{0.5})$, which combination is formally equivalent to a divalent metallic element;

(2) a combination of divalent metallic elements (hereinafter may be referred to as a "divalent metallic element combination"), such as $(Ca_{0.5}Sr_{0.5})$, $(Sr_{0.5}Ba_{0.5})$, or $(Ca_{1/3}Sr_{1/3}Ba_{1/3})$, which combination is formally equivalent to a divalent metallic element;

(3) a combination of a non- divalent metallic element combination and a divalent metallic element, such as $(Bi_{0.5}Na_{0.5})_{0.5}Ca_{0.5}$, $(Bi_{0.5}Na_{0.5})_{0.5}Sr_{0.5}$, $(Bi_{0.5}Na_{0.5})_{0.5}Ba_{0.5}$, $(Bi_{0.5}K_{0.5})_{0.5}Ca_{0.5}$, $(Bi_{0.5}K_{0.5})_{0.5}Sr_{0.5}$, or $(Bi_{0.5}K_{0.5})_{0.5}Ba_{0.5}$, which combination is formally equivalent to a divalent metallic element; and

(4) a combination of a non- divalent metallic element combination and a divalent metallic element combination, such as $(Bi_{0.5}Na_{0.5})_{0.5}(Ca_{0.5}Sr_{0.5})_{0.5}$, $(Bi_{0.5}Na_{0.5})_{0.5}(Sr_{0.5}Ba_{0.5})_{0.5}$, $(Bi_{0.5}K_{0.5})_{0.5}(Ca_{0.5}Sr_{0.5})_{0.5}$, or $(Bi_{0.5}K_{0.5})_{0.5}(Sr_{0.5}Ba_{0.5})_{0.5}$, which combination is formally equivalent to a divalent metallic element.

Preferably, M1 contains at least one of Ca, Sr, Ba, $(Bi_{0.5}Na_{0.5})$, and $(Bi_{0.5}K_{0.5})$ {i.e., M1 contains Ca, Sr, Ba, $(Bi_{0.5}Na_{0.5})$, or $(Bi_{0.5}K_{0.5})$, or at least two of Ca, Sr, Ba, $(Bi_{0.5}Na_{0.5})$, and $(Bi_{0.5}K_{0.5})$ } . This is because, such M1 species exhibit the effect of greatly improving piezoelectric characteristics.

As described above, "M2" represents a tetravalent metallic element, or a metallic element combination formally equivalent to a tetravalent metallic element. Examples of the "tetravalent metallic element" include Ti, Zr, Sn, and Hf. As used herein, the expression "metallic element combination formally equivalent to a tetravalent metallic element" (hereinafter may be referred to simply as "tetravalent combination") refers to the following combinations (1) to (4) :

(1) a combination of tetravalent metallic elements (hereinafter may be referred to as a "tetravalent metallic element combination"), such as $(Ti_{0.5}Zr_{0.5})$, $(Ti_{0.5}Sn_{0.5})$, $(Zr_{0.5}Sn_{0.5})$, or $(Ti_{1/3}Zr_{1/3}Sn_{1/3})$, which combination is formally equivalent to a tetravalent metallic element;

(2) a combination of non- tetravalent metallic elements (hereinafter may be referred to as a "non- tetravalent metallic element combination"), such as $(Mg_{0.33}Ta_{0.67})$, $(Al_{0.5}Ta_{0.5})$, or $(Zn_{0.5}W_{0.5})$, which combination is formally equivalent to a tetravalent metallic element;

(3) a combination of a non- tetravalent metallic element combination and a tetravalent metallic element, such as $Ti_{0.5}(Mg_{0.33}Ta_{0.67})_{0.5}$ or $Ti_{0.5}(Al_{0.5}Ta_{0.5})_{0.5}$, which combination is formally equivalent to a tetravalent metallic element; and

(4) a combination of a tetravalent metallic element combination and a non- tetravalent metallic element combination, such as $(Ti_{0.5}Zr_{0.5})_{0.5}(Mg_{0.33}Ta_{0.67})_{0.5}$ or $(Ti_{0.5}Zr_{0.5})(Al_{0.5}Ta_{0.5})_{0.5}$, which combination is formally equivalent to a tetravalent metallic element.

Preferably, M2 contains at least one of Ti, Zr, and Sn (i.e., M2 contains Ti, Zr, or Sn, or at least two of Ti, Zr, and Sn). This is because, such a tetravalent metallic element exhibits the effect of greatly improving piezoelectric characteristics.

As described above, "M3" represents a metallic element of a sintering aid component. Examples of the sintering aid component, which contains M3 and constitutes a sintering aid, include compounds of M3, such as oxides of M3, carbonates of M3, and hydroxides of M3. Since the piezoelectric ceramic composition contains the sintering aid component, sintering of the composition is promoted, and thus a piezoelectric member formed of the composition can be readily sintered. M3 is a metallic element other than K, Na, Nb, a metallic element employed as M1, and a metallic element employed as M2. M3 is generally a transition metal element, particularly preferably Fe, Co, Ni, Mg, Zn, or Cu. This is because, such a metallic element exhibits particularly excellent effect of densifying the piezoelectric ceramic composition. These metallic elements may be employed singly or in combination of two or more species. In the latter case, preferably, Cu is employed in combination with any of the aforementioned metallic elements. The metallic element employed in combination with Cu is particularly preferably Ni.

When the total amount of K, Na, Nb, M1, and M2 as reduced to corresponding oxides is 100 parts by mass, the amount of M3 as reduced to M3 oxide is 5 parts by mass or less. When the amount of M3 as reduced to M3 oxide exceeds 5 parts by mass, the piezoelectric ceramic composition may exhibit deteriorated piezoelectric characteristics. The M3 content is calculated as the amount of an oxide of M3; i.e., $M3O_n$ (wherein n is an integer or fraction determined depending on the valence of M3). For example, when M3 is Fe, Co, Ni, Cu, Zn, or Mg, the amount of $FeO_{3/2}$, $CoO_{4/3}$, NiO, CuO, ZnO, or MgO is respectively calculated as the M3 content. The lower limit of the amount of M3 as reduced to M3 oxide is 0.1 parts by mass. When the M3 content is 0.1 parts by mass or more, the sinterability of a piezoelectric member formed of the piezoelectric ceramic composition is effectively enhanced, which is preferred. When the total amount of K, Na, Nb, M1, and M2 as reduced to corresponding oxides is 100 parts by mass, the amount of M3 as reduced to M3 oxide is preferably 0.1 to 3.5 parts by mass, particularly preferably 0.1 to 2.0 parts by mass.

No particular limitations are imposed on the combination of M1, M2, and M3. Preferably, M1 contains at least one of Ca, Sr, Ba, $(Bi_{0.5}Na_{0.5})$, and $(Bi_{0.5}K_{0.5})$ as described above; M2 contains at least one of Ti, Zr, and Sn as described above; and M3 contains at least one of Fe, Co, Ni, Mg, Zn, and Cu (in particular, a combination of Cu and Fe, Co, Ni, Mg, or Zn) as described above. When M1, M2, and M3 are combined together under the above- described conditions, the piezoelectric ceramic composition exhibits further improved piezoelectric characteristics.

In the piezoelectric ceramic composition of the present invention, when K, Na, Nb, M1, and M2 constitute the following formula $[(1/2) aK_2O- (1/2) bNa_2O- cM1O- (1/2) dNb_2O_5- eM2O_2]$ (wherein each of K, Na and Nb is a metallic element, and each of M1 and M2 is a metallic element or a metallic element combination), a, b, c, d, and e in the formula, each representing the mole fraction of this metallic element or this metallic element combination as reduced to its oxide, essentially satisfy the below- described predetermined conditions.

The aforementioned "a" represents the mole fraction of K as reduced to its oxide $\{1/2 (K_2O) \}$, and satisfies the following relation: $0 < a < 0.5$ (preferably $0.2 \leq a \leq 0.25$) . When a is 0.5 or more, the sinterability of the piezoelectric ceramic composition may be lowered, which is not preferred.

The aforementioned "b" represents the mole fraction of Na as reduced to its oxide $\{1/2 (Na_2O) \}$, and satisfies the following relation: $0 < b < 0.5$ (preferably $0.2 \leq b \leq 0.25$) . When b is 0.5 or more, the sinterability of the piezoelectric ceramic composition may be lowered, which is not preferred.

The aforementioned "c" represents the mole fraction of M1 as reduced to its oxide (M1O), and satisfies the following relation: $0 < c < 0.11$ (preferably $0.01 \leq c s 0.1$) . When c is 0.11 or more, the piezoelectric characteristics of the piezoelectric ceramic composition may be considerably deteriorated, which is not preferred.

The aforementioned "d" represents the mole fraction of Nb as reduced to its oxide $\{1/2 (Nb_2O_5) \}$, and satisfies the following relation: $0.4 < d < 0.56$ (preferably $0.4 < d < 0.5$) . When d is 0.4 or less, the piezoelectric ceramic composition may fail to attain desired piezoelectric characteristics, whereas when d is 0.56 or more, the piezoelectric characteristics of the composition tend to be deteriorated, which is not preferred.

The aforementioned "e" represents the mole fraction of M2 as reduced to its oxide $(M2O_2)$, and satisfies the following relation: $0 < e < 0.12$ (preferably $0 < e < 0.1$) . When e is 0.12 or more, the piezoelectric ceramic composition may fail to attain desired piezoelectric characteristics, which is not preferred.

The aforementioned "a + b + c" represents the sum of the mole fractions of K, Na, and M1, and satisfies the following relation: $0.4 < a + b + c \leq 0.5$. When the aforementioned "a + b + c" is 0.4 or less or exceeds 0.5, the piezoelectric characteristics of the piezoelectric ceramic composition may be considerably deteriorated, which is not preferred.

The aforementioned "c/ (a + b + c) " represents the ratio of the mole fraction of M1 to the sum of the mole fractions of K, Na, and M1. Specifically, in the piezoelectric ceramic composition of the present invention, when K, Na, Nb, M1, and M2 constitute the following formula $(K_aNa_bM1_c) (Nb_dM2_e) O_3$, the ratio c/ (a + b + c) is the ratio by mole of M1 to the metallic elements contained in the A sites. The ratio c/ (a + b + c) preferably satisfies the following relation: $0 < c/ (a + b + c) s 0.20$. This is because, when the ratio c/ (a + b + c) is 0.20 or less (particularly 0.15 or less), the piezoelectric ceramic composition can attain particularly excellent piezoelectric characteristics.

Among the metallic elements contained in the piezoelectric ceramic composition of the present invention, K and Na (including K and Na contained in M1) may be partially substituted by Li. No particular limitations are imposed on the Li substitution amount, but the ratio by mole of Li to (K + Na); i.e., {Li/(K + Na)}, is generally 0.001 or more and 0.3 or less (preferably 0.2 or less, more preferably 0.15 or less). When the ratio {Li/(K + Na)} is 0.3 or less, the piezoelectric ceramic composition can attain excellent sinterability and piezoelectric characteristics.

Similar to the case of K and Na, Nb (which is one of the metallic elements contained in the piezoelectric ceramic composition of the present invention) may be partially substituted by Ta. No particular limitations are imposed on the Ta substitution amount, but the ratio by mole of Ta to Nb; i.e., (Ta/Nb), is generally 0.001 or more and 0.4 or less (preferably 0.3 or less, more preferably 0.25 or less). When the ratio (Ta/Nb) is 0.4 or less, the piezoelectric ceramic composition can attain excellent sinterability and piezoelectric characteristics.

Nb, which is one of the metallic elements contained in the piezoelectric ceramic composition of the present invention, may also be partially substituted by Sb. No particular limitations are imposed on the Sb substitution amount, but the ratio by mole of Sb to Nb; i.e., (Sb/Nb), is 0.025 or less. When the ratio (Sb/Nb) is 0.025 or less, the relative dielectric constant of the piezoelectric ceramic composition can be enhanced, and generation of leakage current can be effectively suppressed during the course of polarization treatment.

No particular limitations are imposed on the crystal structure of the piezoelectric ceramic composition of the present invention, but generally, the composition is predominantly formed of a perovskite crystal structure. The perovskite crystal structure may belong to any of an orthorhombic crystal system, a cubic crystal system, a tetragonal crystal system, etc., or may be formed of two or more of these crystal systems (wherein these crystal systems may be contained in either the primary crystal phase or the secondary crystal phase). Among these crystal systems, an orthorhombic crystal system is particularly preferred. This is because, when the piezoelectric ceramic composition contains orthorhombic perovskite crystals, the composition exhibits particularly excellent piezoelectric characteristics. Alternatively, the perovskite crystal structure may be formed solely of an orthorhombic perovskite crystal system.

No particular limitations are imposed on the method for producing the piezoelectric ceramic composition of the present invention, but generally, the production method includes the below-described raw material preparation step, calcination step, molding step, firing step, and polarization treatment step.

In the raw material preparation step, the raw material of the piezoelectric ceramic composition is prepared from a K-containing compound, an Na-containing compound, an Nb-containing compound, an M1-containing compound, an M2-containing compound, and an M3-containing compound, such that a, b, c, d, and e in the aforementioned formula (i.e., the mole fractions of the metallic elements contained in these compounds) satisfy the above-described conditions, and that when the total amount of K, Na, Nb, M1, and M2 as reduced to corresponding oxides is 100 parts by mass, the amount of M3 as reduced to M3 oxide is 5 parts by mass or less. A compound containing a divalent combination as M1 or a compound containing a tetravalent combination as M2 may be employed. So long as the mole fractions shown in the formula satisfy the above-described conditions, a compound containing only one single metallic element which constitutes M1 and M2 may be employed.

No particular limitations are imposed on the compound to be employed in the raw material preparation step. Examples of the compound to be employed include oxides, carbonates, hydroxides, hydrogencarbonates, nitrates, and organometallic compounds of the aforementioned metallic elements. No particular limitations are imposed on the form of the compound to be employed, and the compound may be in the form of like powder or liquid. The compound to be employed may contain only one species of the aforementioned metallic elements, or two or more species of the metallic elements.

In the calcination step, the ceramic raw material prepared in the raw material preparation step is calcined. No particular limitations are imposed on the calcination temperature, the calcination time, the calcination atmosphere, etc. For example, the calcination temperature is generally 600 to 1,000°C, which is lower than the below-described firing temperature. The calcination time may be regulated to 1 to 10 hours. The calcination step is generally performed in the atmosphere.

In the molding step, the product obtained through the calcination step is formed into a moldable product, and then the moldable product is subjected to molding. In general, the calcined product is milled, and then mixed with an organic binder, a dispersant, a solvent, etc. Subsequently, the resultant mixture is dried, and then subjected to granulation, to thereby yield granules. Thereafter, the thus-obtained granules are molded into a product having a desired shape. Molding of the granules is generally performed through pressure molding. No particular limitations are imposed on the pressure molding method. For example, the granules may be subjected to primary molding through the uniaxial pressing method, followed by secondary molding through cold isostatic hydraulic press (CIP) treatment or a similar technique.

In the firing step, the product obtained through the molding step is fired. No particular limitations are imposed on the firing temperature, the firing time, the firing atmosphere, etc. For example, the firing temperature is generally 900 to 1,300°C. The firing time may be regulated to 1 to 10 hours. The firing step is generally performed in the atmosphere.

In the polarization treatment step, the ceramic product obtained through the firing step is subjected to polarization treatment such that the ceramic product exhibits piezoelectric characteristics. In general, the polarization treatment can be carried out through the following procedure: electrodes are formed on the ceramic product obtained through the firing step; the resultant ceramic product is placed in an insulated environment (e.g., in a highly insulating liquid) whose temperature is maintained at a predetermined level; and a DC voltage of 0.5 to 5 kV/mm is applied to the electrodes for one minute to 30 minutes. The aforementioned electrodes can be formed through the following procedure: the upper and lower surfaces of the ceramic product obtained through the firing step are polished in parallel; and subsequently a conductive paste is applied to the thus-polished upper and lower surfaces, followed by baking at 600 to 800°C for 10 minutes.

[2] Piezoelectric element

The piezoelectric element of the present invention includes a piezoelectric member formed of the piezoelectric ceramic composition of the present invention; and at least a pair of electrodes which are in contact with the piezoelectric member.

The aforementioned "piezoelectric member," which is a part of the piezoelectric element, exhibits piezoelectric characteristics. No particular limitations are imposed on the form and size of the piezoelectric member. Preferably, the form and size of the piezoelectric member are appropriately determined in accordance with the intended use of the piezoelectric element; for example, a vibration sensor, a pressure sensor, an oscillator, or a piezoelectric device. The piezoelectric member may be in a variety of forms, including a rectangular plate, a circular plate, a plate having, in its center, a through hole provided in a thickness direction, a rectangular column, and a circular column. The piezoelectric element may be formed through stacking of a plurality of piezoelectric members having such a form.

The aforementioned "a pair of electrodes" are electrically conductive layers formed on the surface(s) of the piezoelectric member. These electrodes may be formed respectively on one surface and the other surface of the piezoelectric member, or the electrodes may be formed on the same surface of the piezoelectric member. No particular limitations are imposed on the form, size, material, etc. of the electrodes. Preferably, the form, etc. of the electrodes are appropriately determined in accordance with, for example, the size of the piezoelectric member or the intended use of the piezoelectric element. The electrodes may have a plane form. Particularly when a pair of electrodes are formed on the same surface of the piezoelectric member, the electrodes may have a comb-tooth-like form. No particular limitations are imposed on the method for forming the electrodes, but generally, the electrodes are formed by applying a conductive paste onto the predetermined surface(s) of the piezoelectric member, followed by baking.

Fig. 1 shows a piezoelectric element 1 employed in a non-resonant knock sensor, which is an embodiment of the piezoelectric element of the present invention. The piezoelectric element 100 includes a disk-like piezoelectric member 1 having a through hole 11 in its center; and electrically conductive layers 21 and 22 (a pair of electrodes) which are formed by applying an electrically conductive paste onto the top and bottom surfaces of the piezoelectric member 1, followed by baking.

The conductive paste can be prepared by use of a glass frit, an electrically conductive component, and an organic medium.

The glass frit to be employed may contain, for example, $SiO_2$, $Al_2O_3$, ZnO, or $TiO_2$. This glass frit can enhance the joint strength between the piezoelectric member formed of the piezoelectric ceramic composition and a pair of electrodes.

The electrically conductive component to be employed may be, for example, powder of a noble metal (e.g., silver, gold, palladium, or platinum); a powder mixture containing two or more of such noble metal powders; or powder of an alloy formed of two or more noble metals. Alternatively, the electrically conductive component may be, for example, powder of copper, nickel, or the like; a mixture of such metal powders; or powder of an alloy formed of such metals. This electrically conductive component is particularly preferably silver powder, palladium powder, or powder of a silver-palladium alloy. The average particle size of such electrically conductive powder is preferably 20 μm or less (more preferably 1 to 5 μm). When the average particle size is 20 μm or less, electrodes can be formed through screen printing without firing. This electrically conductive component is generally incorporated such that the amount thereof accounts for 70 to 99 mass% of the solid content of the conductive paste.

The organic medium to be employed may be a medium which is generally employed for preparing such a conductive paste; for example, an alcohol, an ester, or an ether. The organic medium is generally incorporated in an amount of about 10 to about 40 mass% on the basis of the entirety (100 mass%) of the conductive paste.

Examples

The present invention will next be described in detail by way of Examples.

Preparation of piezoelectric member (Test Examples 1 through 20 shown in Table 1)

[1] Commercially available $K_2CO_3$ powder, $Na_2CO_3$ powder, $CaCO_3$ powder, $SrCO_3$ powder, $BaCO_3$ powder, $Bi_2O_3$ powder, $Nb_2O_5$ powder, and $TiO_2$ powder were weighed such that the mole fractions, a, b, c, d, and e in the aforementioned formula, attain the values shown in Table 1, respectively. Subsequently, commercially available $Fe_2O_3$ powder, $Co_3O_4$ powder, and CuO powder were weighed such that the mass of M3 as reduced to M3 oxide attains the value α shown in Table 1 with respect to the total mass of K, Na, Nb, M1, and M2 as reduced to corresponding oxides. These powders were wet-mixed with ethanol by use of a ball mill for 15 hours, to thereby yield a slurry. Thereafter, the slurry was dried, and then the resultant powder mixture was calcined in the atmosphere at 600 to 1, 000°C for one hour to 10 hours. Subsequently, by use of a ball mill, the thus-calcined product was milled and mixed with a dispersant, a binder, and ethanol, to thereby yield a slurry. Thereafter, the slurry was dried and subjected to granulation, and the resultant granules were subjected to uniaxial pressing at 20 MPa, to thereby form the following two types of products: disk-like products (diameter: 20 mm, thickness: 2 mm) and cylindrical products (diameter: 3 mm, height: 8 mm) .

Thereafter, each of the thus-formed products was subjected to CIP treatment at 150 MPa, and the resultant CIP product was fired in the atmosphere at 900 to 1, 300°C for one hour to 10 hours, to thereby prepare a piezoelectric member.

Through the firing step, all the M3-containing CIP products were able to be sintered, but the CIP products of Test Examples 1 through 3, 12, and 13, which do not contain M3, failed to be sintered.

[Table 1]

Table 1

| Test Example | a | b | c | d | e | c/(a+b+c) | M1 | M2 | M3 | $\alpha$ | Firing temperature |
|---|---|---|---|---|---|---|---|---|---|---|---|
| * 1 | 0.2500 | 0.2500 | * 0 | 0.5000 | * 0 | 0 | - | - | - | * - | Not sintered |
| * 2 | 0.2750 | 0.2250 | * 0 | 0.5000 | * 0 | 0 | - | - | - | * - | Not sintered |
| * 3 | 0.2625 | 0.2375 | * 0 | 0.5000 | * 0 | 0 | - | - | - | * - | Not sintered |
| * 4 | 0.2500 | 0.2500 | * 0 | 0.5000 | * 0 | 0 | - | - | Cu | 0.47 | 1050 |
| * 5 | 0.2500 | 0.2500 | * 0 | 0.5000 | * 0 | 0 | - | - | Co | 0.17 | 1050 |
| * 6 | 0.2500 | 0.2500 | * 0 | 0.5000 | * 0 | 0 | - | - | Fe | 0.25 | 1050 |
| 7 | 0.2375 | 0.2375 | 0.0250 | 0.4750 | 0.0250 | 0.0500 | Ca | Ti | Co | 0.17 | 1050 |
| 8 | 0.2375 | 0.2375 | 0.0250 | 0.4750 | 0.0250 | 0.0500 | Sr | Ti | Co | 0.17 | 1050 |
| 9 | 0.2375 | 0.2375 | 0.0250 | 0.4750 | 0.0250 | 0.0500 | Ba | Ti | Co | 0.17 | 1050 |
| 10 | 0.2375 | 0.2375 | 0.0250 | 0.4750 | 0.0250 | 0.0500 | $Bi_{0.5}Na_{0.5}$ | Ti | Co | 0.17 | 1050 |
| 11 | 0.2375 | 0.2375 | 0.0250 | 0.4750 | 0.0250 | 0.0500 | $Bi_{0.5}K_{0.5}$ | Ti | Co | 0.17 | 1050 |
| * 12 | 0.2375 | 0.2375 | 0.0250 | 0.4750 | 0.0250 | 0.0500 | Sr | Ti | - | * - | Not sintered |
| * 13 | 0.2375 | 0.2375 | 0.0250 | 0.4750 | 0.0250 | 0.0500 | $Bi_{0.5}Na_{0.5}$ | Ti | - | * - | Not sintered |
| 14 | 0.2250 | 0.2250 | 0.0500 | 0.4500 | 0.0500 | 0.1000 | Sr | Ti | Co | 0.17 | 1100 |
| 15 | 0.2125 | 0.2125 | 0.0750 | 0.4250 | 0.0750 | 0.1500 | Sr | Ti | Co | 0.17 | 1100 |
| * 16 | 0.1875 | 0.1875 | * 0.1250 | * 0.3750 | * 0.1250 | 0.2500 | Sr | Ti | Co | 0.17 | 1200 |
| 17 | 0.2494 | 0.2256 | 0.0250 | 0.4750 | 0.0250 | 0.0500 | Sr | Ti | Fe | 0.25 | 1050 |
| 18 | 0.2256 | 0.2494 | 0.0250 | 0.4750 | 0.0250 | 0.0500 | Sr | Ti | Fe | 0.25 | 1050 |
| 19 | 0.2438 | 0.2438 | 0.0125 | 0.4876 | 0.0125 | 0.0250 | Sr | Ti | Fe | 0.25 | 1050 |
| 20 | 0.2375 | 0.2375 | 0.0250 | 0.4750 | 0.0250 | 0.0500 | Sr | Ti | Fe | 0.25 | 1050 |

The value of "(a + b)/d" is not described in Table 1, since the ratio (a + b)/d is 1.00 throughout the cases of Test Examples 1 through 20. The piezoelectric members of the Test Examples marked with * shown in Table 1 are comparative products. Values marked with * described in columns "a" through "e" and "$\alpha$" fall outside the scope of the present invention.

[2] Preparation of piezoelectric member (Test Examples 21 through 39 shown in Table 2)

Commercially available $K_2CO_3$ powder, $Na_2CO_3$ powder, $Ca_2CO_3$ powder, $Sr_2CO_3$ powder, $Ba_2CO_3$ powder, $Nb_2O_5$ powder, and $TiO_2$ powder were weighed such that the mole fractions a, b, c, d, and e of the aforementioned formula respectively attain the values shown in Table 2.

In each of the cases of Test Examples 21, 24, 26, 27, and 30 shown in Table 2, $Sb_2O_3$ powder was employed such that Nb in the piezoelectric ceramic composition, which constitutes the formula [(1/2) $aK_2O$- (1/2) $bNa_2O$- $cM1O$- (1/2) $dNb_2O_5$- $eM2O_2$], is partially substituted by Sb, and the employed $Sb_2O_3$ powder was weighed such that the mole fraction d' (Sb) attains the value shown in Table 2 [the mole fraction d shown in Table 2 corresponds to the value which is finally obtained on the basis of the mole fractions of d' (Sb) and $Nb_2O_5$ powder] . In the case of Test Example 31 shown in Table 2, $Ta_2O_5$ powder was employed such that Nb of the piezoelectric ceramic composition, which is represented by the aforementioned formula, is partially substituted by Ta, and the employed $Ta_2O_5$ powder was weighed such that the mole fraction d' (Ta) attains the value shown in Table 2 [the mole fraction d shown in Table 2 corresponds to the value which is finally obtained on the basis of the mole fractions of d' (Ta) and $Nb_2O_5$ powder] . In each of the cases of Test Examples 37 through 39 shown in Table 2, $Li_2CO_3$ powder was employed such that K or Na of the piezoelectric ceramic composition, which is represented by the aforementioned formula, is partially substituted by Li, and the employed $Li_2CO_3$ powder was weighed such that the mole fraction of Li attains the value shown in Table 2 (in each of Test Examples 37 through 39, Li, which can partially substitute for K or Na, is regarded as being substituted only for Na, and thus the mole fraction b shown in Table 2 includes the mole fraction of Li; i.e., the mole fraction b shown in Table 2 corresponds to the value which is finally obtained on the basis of the mole fractions of Li and $Na_2CO_3$ powder) .

Subsequently, commercially available $Co_3O_4$ powder, MgO powder, NiO powder, ZnO powder, and CuO powder were weighed such that the mass of M3 as reduced to M3 oxide attains the value $\alpha$ shown in Table 2 with respect to the total mass of K, Na, Nb, M1, and M2 as reduced to corresponding oxides. These powders were wet- mixed with ethanol by use of a ball mill for 15 hours, to thereby yield a slurry. Thereafter, the slurry was dried, and then the resultant powder mixture was calcined in the atmosphere at 600 to 1, 000°C for one to 10 hours. Subsequently, in a ball mill, the thus- calcined product was milled and mixed with a dispersant, a binder, and ethanol, to thereby yield a slurry. Thereafter, the slurry was dried and subjected to granulation, and the resultant granules were subjected to uniaxial pressing at a pressure of 20 MPa, to thereby form the following two types of products: disk- like products (diameter: 20 mm, thickness: 2 mm) and cylindrical products (diameter: 3 mm, height: 8 mm) .

Thereafter, each of the thus- formed products was subjected to CIP treatment at 150 MPa, and the resultant CIP product was fired in the atmosphere at 900 to 1, 300°C for one hour to 10 hours, to thereby prepare a piezoelectric member. All the CIP products of Test Examples 21 through 39, which contain M3, were able to be sintered.

EP 1 630 149 B1

[Table 2] Table 2

| Test Ex. | a | b | c | d | d'(Sb) | d'(Ta) | e | Li | c/ (a+b+c) | (a+b)/ (d+d') | M1 | M2 | M3 | α | Firing temp. |
|---|---|---|---|---|---|---|---|---|---|---|---|---|---|---|---|
| 21 | 0.2361 | 0.2313 | 0.0254 | 0.4771 | 0.0048 | | 0.0254 | | 0.0515 | 0.970 | Ba | Ti | Cu | 0.50 | 1075 |
| 22 | 0.2361 | 0.2313 | 0.0254 | 0.4819 | | | 0.0254 | | 0.0515 | 0.970 | Ba | Ti | Ni(0.25), Cu(0.25) | 0.50 | 1040 |
| 23 | 0.2361 | 0.2313 | 0.0254 | 0.4819 | | | 0.0254 | | 0.0515 | 0.970 | Ca | Ti | Zn(0.25), Cu(0.25) | 0.50 | 1070 |
| 24 | 0.2361 | 0.2313 | 0.0254 | 0.4723 | 0.0096 | | 0.0254 | | 0.0515 | 0.970 | Ba | Ti | Ni(0.5), Cu(1.0) | 1.50 | 1035 |
| 25 | 0.2361 | 0.2313 | 0.0254 | 0.4819 | | | 0.0254 | | 0.0515 | 0.970 | Ba | Ti | Ni | 0.50 | 1055 |
| 26 | 0.2361 | 0.2313 | 0.0254 | 0.4723 | 0.0096 | | 0.0254 | | 0.0515 | 0.970 | Ba | Ti | Ni | 0.50 | 1070 |
| 27 | 0.2361 | 0.2313 | 0.0254 | 0.4771 | 0.0048 | | 0.0254 | | 0.0515 | 0.970 | Ba | Ti | Ni | 0.50 | 1075 |
| 28 | 0.2361 | 0.2313 | 0.0254 | 0.4819 | | | 0.0254 | | 0.0515 | 0.970 | Ba | Ti | Cu | 2.00 | 955 |
| 29 | 0.2361 | 0.2313 | 0.0254 | 0.4819 | | | 0.0254 | | 0.0515 | 0.970 | Ba | Ti | Ni(0.25), Zn(0.25) | 0.50 | 1075 |
| 30 | 0.2361 | 0.2313 | 0.0254 | 0.4723 | 0.0096 | | 0.0254 | | 0.0515 | 0.970 | Sr | Ti | Ni | 0.50 | 1080 |
| 31 | 0.2361 | 0.2313 | 0.0254 | 0.4337 | | 0.0482 | 0.0254 | | 0.0515 | 0.970 | Ba | Ti | Ni | 0.50 | 1100 |
| 32 | 0.2361 | 0.2313 | 0.0254 | 0.4819 | | | 0.0254 | | 0.0515 | 0.970 | Ba | Ti | Mg | 0.50 | 1060 |
| 33 | 0.2375 | 0.2375 | 0.0250 | 0.4750 | | | 0.0250 | | 0.0500 | 1.000 | Ba | Zr | Co | 0.17 | 1080 |
| 34 | 0.2375 | 0.2375 | 0.0250 | 0.4750 | | | 0.0250 | | 0.0500 | 1.000 | Ba | Sn | Co | 0.17 | 1100 |
| 35 | 0.2361 | 0.2313 | 0.0254 | 0.4819 | | | 0.0254 | | 0.0515 | 0.970 | Ba | Ti | Cu | 5.00 | 1010 |
| * 36 | 0.2361 | 0.2313 | 0.0254 | 0.4819 | | | 0.0254 | | 0.0515 | 0.970 | Ba | Ti | Cu | * 6.00 | 1000 |
| 37 | 0.2361 | 0.1813 | 0.0254 | 0.4819 | | | 0.0254 | 0.05 | 0.0573 | 0.866 | Ba | Ti | Ni | 0.50 | 1075 |
| 38 | 0.2361 | 0.2113 | 0.0254 | 0.4819 | | | 0.0254 | 0.02 | 0.0536 | 0.929 | Ba | Ti | Cu(0.25), Ni(0.25) | 0.50 | 1075 |
| 39 | 0.2361 | 0.1813 | 0.0254 | 0.4819 | | | 0.0254 | 0.05 | 0.0573 | 0.866 | Ba | Ti | Cu(0.25), Ni(0.25) | 0.50 | 1075 |

The piezoelectric member of the Test Example marked with * shown in Table 2 is a comparative product. The value marked with * described in column "$\alpha$" falls outside the scope of the present invention.

[3] Production of piezoelectric element (formation of electrodes)

The upper and lower surfaces of each of the above-sintered piezoelectric members (disk-like and cylindrical members) of Test Examples shown in Tables 1 and 2 were polished in paearell. Subsequently, a conductive paste, which had been prepared by use of a glass frit containing $SiO_2$, $Al_2O_3$, ZnO, and $TiO_2$, silver powder, and an organic medium, was applied onto the thus-polished upper and lower surfaces through screen printing, followed by baking at 600 to 800°C for 10 minutes, to thereby form electrodes. The sintered member having the thus-formed electrodes was immersed in an insulating oil (a silicone oil) whose temperature was maintained at 20 to 200°C, and the sintered member was subjected to polarization treatment under application of a DC voltage of 0.5 to 5 kV/mm for one minute to 30 minutes, to thereby produce a piezoelectric element.

[4] Evaluation of piezoelectric characteristics

Each of the piezoelectric elements produced above in [3] from the piezoelectric members prepared above in [1] was subjected to evaluation in terms of piezoelectric characteristics in accordance with the EMAS 6000 series. The results are shown in Table 3. Piezoelectric characteristics described in Table 3 are as follows.

$\varepsilon_{33}^T/\varepsilon_0$: relative dielectric constant

$k_r$: electromechanical coupling coefficient before heating (extensional vibration mode of disk- like element)

$k_r^*$: electromechanical coupling coefficient after heating (extensional vibration mode of disk- like element)

$\Delta k_r$: percent reduction in $k_r$ $\{(k_r - k_r^*)/k_r \times 100$, unit: %\}

$k_{33}$: electromechanical coupling coefficient before heating (vertical vibration mode of cylindrical element)

$k_{33}^*$: electromechanical coupling coefficient after heating (vertical vibration mode of cylindrical element)

$\Delta k_{33}$: percent reduction in $k_{33}$ $\{(k_{33} - k_{33}^*)/k_{33} \times 100$, unit: %\}

$d_{33}$: piezoelectric strain constant before heating (unit: pC/N)

$d_{33}^*$: piezoelectric strain constant after heating (unit: pC/N)

$\Delta d_{33}$: percent reduction in $d_{33}$ $\{(d_{33} - d_{33}^*)/d_{33} \times 100$, unit: %\}

Each of the piezoelectric elements produced above in [3] from the piezoelectric members prepared above in [2] was subjected to evaluation in terms of piezoelectric characteristics in accordance with the EMAS 6000 series. The results are shown in Table 4. As shown in Table 4, each of these piezoelectric elements was subjected to evaluation in terms of $\varepsilon_{33}^T/\varepsilon_0$, $k_r$, and $d_{33}$, which are particularly important among the above- described 10 piezoelectric characteristics. Of these characteristics, the relative dielectric constant was calculated from the capacitance at 1 kHz by means of an impedance analyzer (model: HP4194A, product of Hewlett- Packard Company) . The electromechanical coupling coefficient was obtained through the resonance- antiresonance method, and the piezoelectric strain constant was calculated on the basis of the thus- obtained values. As used herein, the expression "electromechanical coupling coefficient (or piezoelectric strain constant) after heating" refers to the electromechanical coupling coefficient (or piezoelectric strain constant) of a piezoelectric element measured after the element is maintained at 200°C for one hour.

[Table 3] Table 3

| Test Ex. | $\varepsilon_{33}^T/\varepsilon_0$ | $k_r$ | $k_r^*$ | $\Delta k_r$ (%) | $k_{33}$ | $k_{33}^*$ | $\Delta k_{33}$ (%) | $d_{33}$ (pC/N) | $d_{33}^*$ (pC/N) | $\Delta d_{33}$ (%) | Perovskite crystals |
|---|---|---|---|---|---|---|---|---|---|---|---|
| *1 | Not measured | | | | | | | | | | Ortho |
| *2 | Not measured | | | | | | | | | | Ortho |
| *3 | Not measured | | | | | | | | | | Ortho |
| *4 | 250 | 0.313 | 0.105 | 66.3 | 0.448 | 0.163 | 63.7 | 66 | 25 | 62.6 | Ortho |
| *5 | 390 | 0.408 | 0.270 | 33.7 | 0.515 | 0.317 | 38.5 | 101 | 67 | 33.4 | Ortho |
| *6 | 440 | 0.309 | 0.238 | 23.1 | 0.411 | 0.285 | 30.6 | 84 | 65 | 23.0 | Ortho |
| 7 | 1120 | 0.212 | 0.162 | 23.8 | 0.274 | 0.198 | 27.7 | 101 | 73 | 28.0 | Ortho |
| 8 | 1060 | 0.318 | 0.281 | 11.7 | 0.368 | 0.328 | 10.8 | 127 | 113 | 11.0 | Ortho |
| 9 | 970 | 0.304 | 0.274 | 9.7 | 0.322 | 0.300 | 6.7 | 104 | 97 | 6.4 | Ortho |

(continued)

| Test Ex. | $\varepsilon_{33}^{T}/\varepsilon_0$ | $k_r$ | $k_r{}^*$ | $\Delta k_r$ (%) | $k_{33}$ | $k_{33}{}^*$ | $\Delta k_{33}$ (%) | $d_{33}$ (pC/N) | $d_{33}{}^*$ (pC/N) | $\Delta d_{33}$ (%) | Perovskite crystals |
|---|---|---|---|---|---|---|---|---|---|---|---|
| 10 | 1090 | 0.291 | 0.262 | 10.0 | 0.363 | 0.334 | 8.0 | 120 | 107 | 10.4 | Ortho |
| 11 | 1160 | 0.270 | 0.223 | 17.5 | 0.307 | 0.265 | 13.7 | 102 | 87 | 15.4 | Ortho |
| *12 | Not measured | | | | | | | | | | Ortho |
| *13 | Not measured | | | | | | | | | | Ortho |
| 14 | 590 | 0.415 | 0.363 | 12.7 | 0.530 | 0.474 | 10.7 | 133 | 117 | 11.9 | Ortho |
| 15 | 660 | 0.295 | 0.252 | 14.7 | 0.362 | 0.327 | 9.7 | 91 | 83 | 8.1 | Ortho |
| *16 | Not resonated | | | | | | | | | | Cubic |
| 17 | 1120 | 0.344 | 0.269 | 22.0 | 0.410 | 0.340 | 16.5 | 149 | 122 | 18.3 | Ortho |
| 18 | 1020 | 0.358 | 0.286 | 20.2 | 0.430 | 0.340 | 22.1 | 154 | 116 | 24.4 | Ortho |
| 19 | 620 | 0.287 | 0.239 | 16.8 | 0.400 | 0.330 | 17.8 | 104 | 84 | 18.8 | Ortho |
| 20 | 1390 | 0.392 | 0.331 | 15.6 | 0.440 | 0.350 | 20.1 | 189 | 145 | 23.4 | Ortho |

In Table 3, the piezoelectric elements of the Test Examples marked with * are comparative products.

[Table 4]

Table 4

| Test Example | $\varepsilon_{33}^{T}/\varepsilon_0$ | $k_r$ | $d_{33}$ (pC/N) | Perovskite crystals |
|---|---|---|---|---|
| 21 | 1190 | 0.250 | 120 | Ortho |
| 22 | 1120 | 0.330 | 136 | Ortho |
| 23 | 1330 | 0.290 | 121 | Ortho |
| 24 | 1535 | 0.270 | 130 | Ortho |
| 25 | 1000 | 0.310 | 140 | Ortho |
| 26 | 1400 | 0.400 | 200 | Ortho |
| 27 | 1300 | 0.370 | 170 | Ortho |
| 28 | 1140 | 0.290 | 135 | Ortho |
| 29 | 1070 | 0.280 | 115 | Ortho |
| 30 | 1400 | 0.220 | 100 | Ortho |
| 31 | 1000 | 0.260 | 120 | Ortho |
| 32 | 1420 | 0.226 | 100 | Ortho |
| 33 | 700 | 0.300 | 110 | Ortho |
| 34 | 700 | 0.200 | 70 | Ortho |
| 35 | 1380 | 0.150 | 65 | Ortho |
| *36 | Not resonated | | | Cubic |
| 37 | 1000 | 0.180 | 50 | Ortho |
| 38 | 1100 | 0.340 | 140 | Ortho |
| 39 | 1100 | 0.210 | 70 | Ortho |

In Table 4, the piezoelectric element of the Test Example marked with * is a comparative product.

[3] Identification of crystal phase

The crystal phase of each of the sintered members prepared above in [1] and [2] was identified by use of an X-ray diffractometer. As a result, all the piezoelectric members of Test Examples were found to contain perovskite crystals. When the perovskite crystals belong to an orthorhombic system, "Ortho" is described in the column "Perovskite crystals" in Tables 3 and 4, whereas when the perovskite crystal belongs to a cubic system, "Cubic" is described in the column "Perovskite crystals."

[4] Results

(1) Sinterability

All the M3-containing piezoelectric ceramic compositions were able to be sintered, but the piezoelectric ceramic compositions of Test Examples 1 through 3, 12, and 13, which do not contain M3, failed to be sintered. The results of Test Examples 1 through 3 reveal that, regardless of M1 or M2, piezoelectric ceramic compositions which do not contain M3 fail to be sintered, even when the mole fraction of K or Na is changed. The results of the piezoelectric ceramic composition of Test Example 12 (which differs from that of Test Example 8 only in the absence of M3) and the results of the piezoelectric ceramic composition of Test Example 13 (which differs from that of Test Example 10 only in the absence of M3) reveal that incorporation of M3 into a piezoelectric ceramic composition enables the composition to be sintered.

(2) Piezoelectric characteristics

The piezoelectric elements of Test Examples 4 through 6, which are comparative products containing neither M1 nor M2, exhibited a low relative dielectric constant ($\varepsilon_{33}^T/\varepsilon_0$) of 250 to 440. The piezoelectric element of Test Example 16, in which c, d, and e fall outside the scope of the present invention, failed to exhibit piezoelectric characteristics. The M3- containing piezoelectric element (piezoelectric member) of Test Example 36, in which the amount of M3 as reduced to M3 oxide exceeds 5 parts by mass with respect to the total mass of K, Na, Nb, M1, and M2 as reduced to corresponding oxides, was able to be sintered, but failed to exhibit piezoelectric characteristics.
In contrast, the piezoelectric elements of Test Examples 7 through 11, 14, 15, 17 through 35, and 37 through 39, which are invention products, exhibited a relative dielectric constant ($\varepsilon_{33}^T/\varepsilon_0$) of 590 to 1, 535. Particularly, the piezoelectric elements of Test Examples 7, 8, 10, 11, 17, 18, 20 through 32, 35, and 37 through 39 exhibited a relative dielectric constant ($\varepsilon_{33}^T/\varepsilon_0$) of 1, 000 or more. Among these piezoelectric elements, the piezoelectric element of Test Example 24 exhibited a very high $\varepsilon_{33}^T/\varepsilon_0$ of 1, 535.

The piezoelectric elements of Test Examples 7 through 11, 14, 15, 17 through 35, and 37 through 39, which are invention products, exhibited an electromechanical coupling coefficient before heating ($k_r$) of 0.150 to 0.415. Particularly, the piezoelectric elements of Test Examples 8, 9, 14, 17, 18, 20, 22, 25 through 27, 33, and 38 exhibited a $k_r$ of 0.300 or more. Among these piezoelectric elements, the piezoelectric elements of Test Examples 14 and 26 exhibited a very high $k_r$ of 0.400 or more. Similarly, these invention products (note: the piezoelectric elements of Test Examples 21 through 39 were not subjected to evaluation of electromechanical coupling coefficient ($k_{33}$)) exhibited a $k_{33}$ of 0.274 to 0.530. Particularly, the piezoelectric elements other than the piezoelectric element of Test Example 7 exhibited a high $k_{33}$ of 0.307 to 0.530. These invention products exhibited a piezoelectric strain constant before heating ($d_{33}$) of 50 to 200 pC/N, and the piezoelectric elements of Test Examples 18, 20, 26, and 27 exhibited a $d_{33}$ of more than 150 pC/N. Particularly, the piezoelectric element of Test Example 26 exhibited a very high $d_{33}$ of 200 pC/N.

(3) Heat durability

In the piezoelectric elements of Test Examples 4 through 6, which are comparative products, all the $\Delta k_r$, $\Delta k_{33}$, and $\Delta d_{33}$ were found to be 30% or higher. That is, these piezoelectric elements exhibited lowered heat durability.
In contrast, in the piezoelectric elements of Test Examples 7 through 11, 14, 15, and 17 through 20, which are invention products, all the $\Delta k_r$, $\Delta k_{33}$, and $\Delta d_{33}$ were suppressed to 28% or less. Particularly, in the piezoelectric elements other than the piezoelectric element of Test Example 7 (which contains Ca as M1), all the $\Delta k_r$, $\Delta k_{33}$, and $\Delta d_{33}$ were suppressed to 24.4% or less. Furthermore, in the piezoelectric elements of Test Examples 8 through 11, 14, 15, and 19, all the $\Delta k_r$, $\Delta k_{33}$, and $\Delta d_{33}$ were suppressed to 20% or less; i.e., these piezoelectric elements exhibited very excellent heat durability (note: the piezoelectric elements of Test Examples 21 through 39 were not subjected to characteristic evaluation after heating).

(4) Crystal phase

Each of the piezoelectric elements of Test Examples 7 through 11, 14, 15, 17 through 35, and 37 through 39, which are invention products, was found to have an orthorhombic perovskite crystal structure.

**Claims**

1. A piezoelectric ceramic composition **characterized by** containing:

   metallic element K;
   metallic element Na;
   metallic element Nb;
   M1, which represents a divalent metallic element, or a metallic element combination formally equivalent to a divalent metallic element;
   M2, which represents a tetravalent metallic element, or a metallic element combination formally equivalent to a tetravalent metallic element;
   M3, which represents a metallic element of a sintering aid component and which is at least one of Fe, Co, Ni, Mg, Zn, and Cu; and
   non- metallic element O, wherein, when K, Na, Nb, M1, and M2 constitute the formula $[(1/2) aK_2O-(1/2) bNa_2O-cM1O-(1/2) dNb_2O_5-eM2O_2]$, a, b, c, d, and e in the formula satisfy the following relations:

   $0 < a < 0.5$,
   $0 < b \leq 0.25$,
   $0 < c < 0.11$,
   $0.4 < d < 0.56$,
   $0 < e < 0.12$,
   $0.4 < a + b + c \leq 0.5$, and
   $a + b + c + d + e = 1$; and when the total amount of K, Na, Nb, M1, and M2 as reduced to corresponding oxides is 100 parts by mass, the amount of M3 as reduced to M3 oxide is 5 parts by mass or less.

2. A piezoelectric ceramic composition as described in claim 1, wherein, when the total amount of K, Na, Nb, M1, and M2 as reduced to corresponding oxides is 100 parts by mass, the amount of M3 as reduced to M3 oxide is 0.1 parts by mass or more.

3. A piezoelectric ceramic composition as described in claim 1 or 2, wherein M1 is at least one of Ca, Sr, Ba, $(Bi_{0.5}Na_{0.5})$, and $(Bi_{0.5}K_{0.5})$ .

4. A piezoelectric ceramic composition as described in any of claims 1 through 3, wherein M2 is at least one of Ti, Zr, and Sn.

5. A piezoelectric ceramic composition as described in any of claims 1 through 4, wherein M3 is a combination of Cu and at least one of Fe, Co, Ni, Mg, and Zn.

6. A piezoelectric ceramic composition as described in any of claims 1 to 5, wherein a, b, and d in the formula satisfy the following relation: $(a + b)/d \leq 1.00$.

7. A piezoelectric ceramic composition as described in any of claims 1 to 6, wherein a, b, and c in the formula satisfy the following relation:

$$0 < c/(a + b + c) \leq 0.20.$$

8. A piezoelectric ceramic composition as described in any of claims 1 to 7, which contains, in addition to K, Na, Nb, M1, M2, and M3, metallic element Li, wherein at least one of K and Na in the formula is partially substituted by Li.

9. A piezoelectric ceramic composition as described in any of claims 1 to 8, which contains, in addition to K, Na, Nb, M1, M2, and M3, metallic element Ta, wherein Nb in the formula is partially substituted by Ta.

10. A piezoelectric ceramic composition as described in any of claims 1 to 9, which contains, in addition to K, Na, Nb, M1, M2, and M3, metallic element Sb, wherein Nb in the formula is partially substituted by Sb.

11. A piezoelectric ceramic composition as described in any of claims 1 to 10, which has a perovskite crystal structure.

12. A piezoelectric ceramic composition as described in claim 11, wherein perovskite crystals belong to an orthorhombic system. ,

13. A piezoelectric element **characterized by** comprising a piezoelectric member formed of a piezoelectric ceramic composition as recited in any of claims 1 to 12; and at least a pair of electrodes which are in contact with the piezoelectric member.

**Patentansprüche**

1. Piezoelektrische Keramikzusammensetzung, **dadurch gekennzeichnet, dass** sie enthält:

   metallisches Element K;
   metallisches Element Na;
   metallisches Element Nb;
   M 1 , das ein bivalentes metallisches Element oder eine Metallelementkombination, die formal äquivalent zu einem bivalenten metallischen Element ist, darstellt;
   M2, das ein tetravalentes metallisches Element oder eine Metallelementkombination, die formal äquivalent zu einem tetravalenten metallischen Element ist, darstellt;
   M3, das ein metallisches Element einer Sinterhilfskomponente darstellt und das mindestens eines von Fe, Co, Ni, Mg, Zn und Cu ist; und
   nichtmetallisches Element O, wobei, wenn K, Na, Nb, M1 und M2 die Formel $[(1/2) aK_2O- (1/2) bNa_2O- cM1O- (1/2) dNb_2O_5- eM2O_2]$ darstellen, a, b, c, d und e in der Formel die folgenden Beziehungen erfüllen

   $0 < a < 0, 5,$
   $0 < b \leq 0,25,$
   $0 < c < 0,11,$
   $0,4 < d < 0,56,$
   $0 < e < 0,12,$
   $0,4 < a + b + c \leq 0,5$ und
   $a + b + c + d + e = 1$; und, wenn die Gesamtmenge von K, Na, Nb, M1 und M2, reduziert zu entsprechenden Oxiden, 100 Masseteile beträgt, die Menge an M3, reduziert zu M3-Oxid, 5 Masseteile oder weniger beträgt.

2. Piezoelektrische Keramikzusammensetzung nach Anspruch 1, wobei, wenn die Gesamtmenge von K, Na, Nb, M1 und M2, reduziert zu entsprechenden Oxiden, 100 Masseteile beträgt, die Menge an M3, zu M3-Oxid reduziert, 0,1 Masseteile oder mehr beträgt.

3. Piezoelektrische Keramikzusammensetzung nach Anspruch 1 oder 2, wobei M1 mindestens eines von Ca, Sr, Ba, $(Bi_{0,5}Na_{0,5})$ und $(Bi_{0,5}K_{0,5})$ ist.

4. Piezoelektrische Keramikzusammensetzung nach einem der Ansprüche 1 bis 3, wobei M2 mindestens eines von Ti, Zr und Sn ist.

5. Piezoelektrische Keramikzusammensetzung nach einem der Ansprüche 1 bis 4, wobei M3 eine Kombination von Cu und mindestens einem von Fe, Co, Ni, Mg und Zn ist.

6. Piezoelektrische Keramikzusammensetzung nach einem der Ansprüche 1 bis 5, wobei a, b und d in der Formel die folgende Beziehung erfüllen: $(a + b)/d \leq 1,00$.

7. Piezoelektrische Keramikzusammensetzung nach einem der Ansprüche 1 bis 6, wobei a, b und c in der Formel die folgende Beziehung erfüllen:

$$0 < c/(a + b + c) \leq 0,20.$$

**8.** Piezoelektrische Keramikzusammensetzung nach einem der Ansprüche 1 bis 7, die zusätzlich zu K, Na, Nb, M1, M2 und M3 das metallische Element Li enthält, wobei mindestens eines von K und Na in der Formel teilweise durch Li substituiert ist.

**9.** Piezoelektrische Keramikzusammensetzung nach einem der Ansprüche 1 bis 8, die zusätzlich zu K, Na, Nb, M1, M2 und M3 das metallische Element Ta enthält, wobei Nb in der Formel teilweise durch Ta substituiert ist.

**10.** Piezoelektrische Keramikzusammensetzung nach einem der Ansprüche 1 bis 9, die zusätzlich zu K, Na, Nb, M1, M2 und M3 das metallische Element Sb enthält, wobei Nb in der Formel teilweise durch Sb substituiert ist.

**11.** Piezoelektrische Keramikzusammensetzung nach einem der Ansprüche 1 bis 10, die eine Perovskitkristallstruktur aufweist.

**12.** Piezoelektrische Keramikzusammensetzung nach Anspruch 11, wobei Perovskitkristalle zu einem orthorhombischen System gehören.

**13.** Piezoelektrisches Element, **dadurch gekennzeichnet, dass** es ein piezoelektrisches Element, das aus einer piezoelektrischen Keramikzusammensetzung nach einem der Ansprüche 1 bs 12 gebildet ist; und mindestens ein Paar von Elektroden, die mit dem piezoelektrischen Element in Kontakt stehen, umfasst.

**Revendications**

**1.** Composition céramique piézoélectrique, **caractérisée en ce qu'**elle contient :

un élément métallique K ;
un élément métallique Na ;
un élément métallique Nb ;
M1, qui représente un élément métallique bivalent ou une combinaison d'éléments métalliques parfaitement équivalente à un élément métallique bivalent ;
M2, qui représente un élément métallique tétravalent ou une combinaison d'éléments métalliques parfaitement équivalente à un élément métallique tétravalent ;
M3, qui représente un élément métallique d'un adjuvant de frittage et qui est au moins un élément parmi Fe, Co, Ni, Mg, Zn et Cu ; et
un élément non métallique O, sachant que, lorsque K, Na, Nb, M1 et M2 composent la formule [(1/2) $aK_2O$-(1/2) $bNa_2O$- $cM1O$- (1/2) $dNb_2O_5$- $eM2O_2$], a, b, c, d et e satisfont les relations suivantes dans la formule :

$0 < a < 0, 5$,
$0 < b \leq 0,25$,
$0 < c < 0,11$,
$0,4 < d < 0,56$,
$0 < e < 0,12$,
$0,4 < a + b + c \leq 0,5$, et
$a + b + c + d + e = 1$ ; et quand la quantité totale de K, Na, Nb, M1 et M2 réduite en oxydes correspondants est de 100 parties en poids, la quantité de M3 réduite en oxyde de M3 est de 5 parties en poids ou moins.

**2.** Composition céramique piézoélectrique selon la revendication 1, dans laquelle, quand la quantité totale de K, Na, Nb, M1 et M2 réduite en oxydes correspondants est de 100 parties en poids, la quantité de M3 réduite en oxyde de M3 est de 0,1 partie en poids ou plus.

**3.** Composition céramique piézoélectrique selon la revendication 1 ou 2, dans laquelle M1 est au moins un élément ou un composé parmi Ca, Sr, Ba, $(Bi_{0,5}Na_{0,5})$ et $(Bi_{0,5}K_{0,5})$ .

**4.** Composition céramique piézoélectrique selon l'une quelconque des revendications 1 à 3, dans laquelle M2 est au moins un élément parmi Ti, Zr et Sn.

**5.** Composition céramique piézoélectrique selon l'une quelconque des revendications 1 à 4, dans laquelle M3 est une combinaison de Cu et d'au moins un élément parmi Fe, Co, Ni, Mg et Zn.

**6.** Composition céramique piézoélectrique selon l'une quelconque des revendications 1 à 5, dans laquelle a, b et d satisfont la relation suivante dans la formule : $(a + b)/D \leq 1,00$.

**7.** Composition céramique piézoélectrique selon l'une quelconque des revendications 1 à 6, dans laquelle a, b et c satisfont la relation suivante dans la formule :

$$0 < c/(a + b + c) \leq 0,20.$$

**8.** Composition céramique piézoélectrique selon l'une quelconque des revendications 1 à 7, qui contient, outre K, Na, Nb, M1, M2 et M3, l'élément métallique Li, au moins un élément parmi K et Na étant partiellement remplacé par Li dans la formule.

**9.** Composition céramique piézoélectrique selon l'une quelconque des revendications 1 à 8, qui contient, outre K, Na, Nb, M1, M2 et M3, l'élément métallique La, Nb étant partiellement remplacé par Ta dans la formule.

**10.** Composition céramique piézoélectrique selon l'une quelconque des revendications 1 à 9, qui contient, outre K, Na, Nb, M1, M2 et M3, l'élément métallique Sb, Nb étant partiellement remplacé par Sb dans la formule.

**11.** Composition céramique piézoélectrique selon l'une quelconque des revendications 1 à 10, qui a une structure cristalline de pérovskite.

**12.** Composition céramique piézoélectrique selon la revendication 11, dans laquelle les cristaux de pérovskite appartiennent au système orthorhombique.

**13.** Elément piézoélectrique **caractérisé en ce qu'**il comprend une partie piézoélectrique faite d'une composition céramique piézoélectrique selon l'une quelconque des revendications 1 à 12, et au moins une paire d'électrodes au contact de la partie piézoélectrique.

Fig. 1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 56012031 A

- JP 11228227 A